# EUROPEAN PATENT APPLICATION

(11) **EP 2 058 908 A1**
(43) Date of publication of application: **13.05.2009**
(21) Application number: 07291283.5
(22) Date of filing: 22.10.2007
(51) Int. Cl.: H01S 5/183, H01S 5/042

(54) **Structure for an optoelectronical device including micropillar like semi-conductors and corresponding processes.**

(71) Applicant: COMMISSARIAT A L'ENERGIE ATOMIQUE, 75015 Paris (FR); Universität Würzburg, 97070 Würzburg (DE)
(72) Inventor: Grenouillet Laurent, 38140 Rives (FR); Claudon Julien, 38000 Grenoble (FR); Forchel Alfred, 97074 Würzburg (DE); Gerard Jean-Michel, 38410 ST Martin D'uriage (FR); Gilet Philppe, 38210 Saint Quentin Sur isere (FR); Höfling Sven, 97225 Zellingen-Retzbach (DE); Reitzenstein Stephan, 97218 Gerbrunn (DE)
(74) Representative: Corret, Hélène

(57) **Abstract**

The invention concerns a structure for an optoelectronical device including at least one micropillar-like semi-conductor (3) and having an electrical contact area on the periphery (30) of the said at least one micropillar, located close to a free end of the said at least one micropillar, the said free end (31) being not involved in the electrical contact.

## Description

The invention is generally related to the field of optoelectronics. More specifically, it concerns the realization of electrically controlled light emitting or detecting devices based on low dimensionality semi-conductors structures.

As nanotechnology techniques drive more and more optoelectronics, devices whose size ranges from several microns down hundreds of nanometers come into prominence.

These micro or nano devices can be designed as diodes (p-i-n junctions) in order to allow current injection. Among these structures, which are generally defined by lithography and etching of planar material generally grown by epitaxy (MBE : Molecular Beam Epitaxy or MOVPE : Metal Organic Vapour Phase Epitaxy) on a given substrate, micropillars have a pillar shape and dimensions lower than 10 µm in diameter and larger that 3 µm in height.

Electrons and holes injected through the n- and p-doped regions from electron-hole pairs in the intrinsic region, *i.e.* in the active material (quantum dots, quantum wells, etc), giving rise to photon generation through radiative recombination. An important advantage of the pillar geometry is the excellent light extraction outside the semi-conductor material in the vertical direction (i.e. perpendicular to the growth plane or substrate).

Micropillars can be optically excited for preliminary investigations, but in fine the real interest is to drive them with an electrical current by electrical injection. However, electrical injection means that an electrical contact must be deposited on the bottom layer and another one on the top layer of the micro or nano-pillar.

An electrical contact on the top layer can be obtained by means of the deposition of a conductive layer.

This layer has to be as transparent as possible and therefore can be composed of either a thin metal (semi-transparent) layer or a conducting oxide such as ITO (Indium Tin Oxide). However, in any case, this layer absorbs part of the light emitted by the source.

In conventional devices such as Vertical-Cavity Surface-Emitting Lasers (VCSELs), for which typical lateral dimensions range from 30 to 50pm, the top contact has a ring-shape around 5µm in width. Taking into account the size of device, the deposition of the conduction layer does not affect light emission (or reception in the case of photodetector).

Current injection in micropillar-like devices with diameters below 10 µm requires first planarization of these high aspect ratio structures (in which their lateral size is lower than their height) and then deposition of a conduction layer on top of the surface. However, most of materials having good electrical conduction properties absorb light. Due to the very small area of the top surface of a micropillar-like device, the use of a light absorbing layer is a main drawback.

It is therefore an object of the invention to obviate this drawback by proposing a method of producing an optoelectronical device including at least one micropillar-like semi-conductor, according to which a light absorbing layer is not longer necessary to get an electrical contact.

Moreover, the method according to the invention can improve electrical injection in such high aspect ratio structures.

The preferred embodiment provides a method of producing an optoelectronical device including at least one micropillar-like semi-conductor, comprising:
- forming at least one micropillar from a planar microcavity structure,
- providing a first electrical contact area on the said structure,
- providing a second electrical contact area on the said at least one micropillar,
wherein the second electrical contact area is provided on the top periphery of the said at least one micropillar, opposite the said structure, its top surface being free of any material, to enable lateral electrical injection.

Therefore, current injection is no longer achieved through a metallic plane layer on top of the device, but via a generally vertical metallic layer at the circumference of the device.

This allows one to get rid of any absorbing top layer without impinging on the injection efficiency. The solution is therefore very attractive with respect to efficient light in- and out-coupling in electrically driven micropillar based light detectors and sources.

The method is further characterized by the following features:
- the second electrical contact area is produced by deposition of a layer of an electrical conductor material.
- the second electrical contact area is created after the said at least one micropillar is formed.
- forming the said at least one micropillar comprises the steps of:
   - providing at least one hard mask on the said planar microcavity structure,
   - etching the said structure in order to define the said at least one micropillar.

According to a first variant of the method according to the invention, the said at least one hard mask is left on the top surface of the said at least one micropillar during the realization of the second electrical contact area.

The first variant is further characterized by the following features:
- providing the second electrical contact area comprises the steps of:
   - planarizing the said at least one micropillar,
   - etching the planariser in order to expose the said at least one micropillar on its top periphery,
   - forming a layer of conductive material which covers the top periphery of the micropillar and the hard mask,
   - etching the said at least one micropillar in order to remove the conductive material from the hard mask while it remains on its top periphery,
   - removing the hard mask.
- said layer of conductive material is obtained by conformal disposition.
- etching is carried out after having protected the top periphery of the said at least one micropillar.

According to a second variant of the method according to the invention, the said at least one hard mask is completely removed from the top surface of the said at least one micropillar, whereby the top periphery of the said at least one micropillar is generally conical-shaped or tapered.

This second variant is further characterized by the following features:
- providing the second electrical contact area comprises the steps of:
   - planarizing the said at least one micropillar,
   - forming a layer of conductive material which leaves exposed the top surface of the said at least one micropillar.
- the said layer of conductive material is obtained by lithography and metallization.

It is another object of the invention to provide a structure for an optoelectronical device which improves light emission.

The preferred embodiment is a structure including at least one micropillar-like semi-conductor and having an electrical contact area on the periphery of the said at least one micropillar, located close to a free end of the said at least one micropillar, the said free end being not involved in the electrical contact.

This structure is further characterized by the following features:
- the said electrical contact area comprises a layer of a conductive material which leaves exposed the free end of the said at least one micropillar.
- said periphery of the said at least one micropillar has a tapered shape.

Preferred embodiments of the invention will now be described with reference to the accompanying drawings, wherein:
- figure 1 includes the figures 1A to 1G which show the various steps of a first method of producing an optoelectronical device according to the invention,
- figure 2 is a cross-sectional schematic view of an optoelectronical device obtained by the first method according to the invention, and illustrates the operation of the device,
- figure 3 includes the figures 3A to 3D which show the various steps of a second method of producing an optoelectronical device according to the invention,
- figure 4 is a cross-sectional schematic view of an optoelectronical device obtained by the second method according to the invention, and illustrates the operation of the device, and
- figure 5 is a curve representing the current flowing in the device according to figure 4 as a function of the voltage applied to the device.

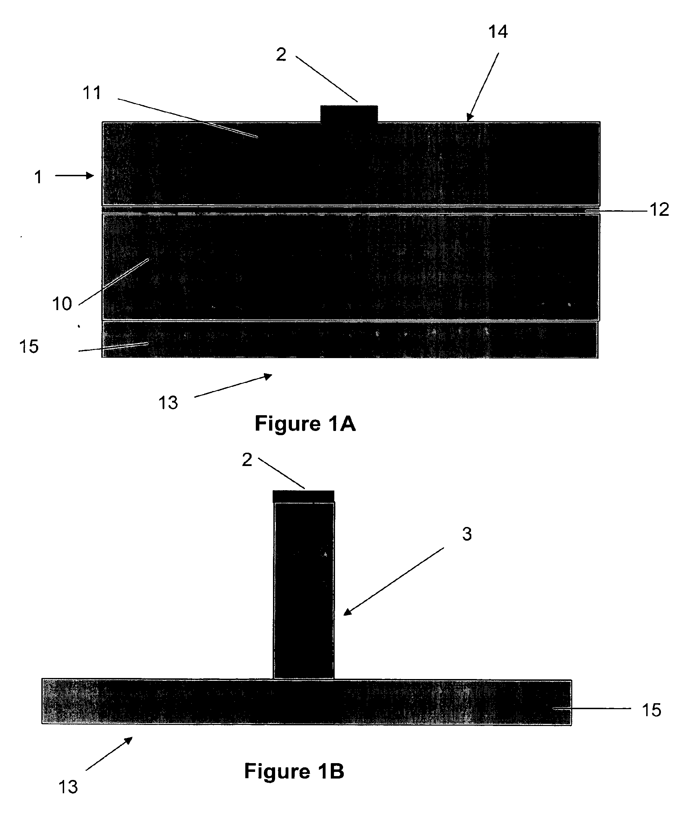

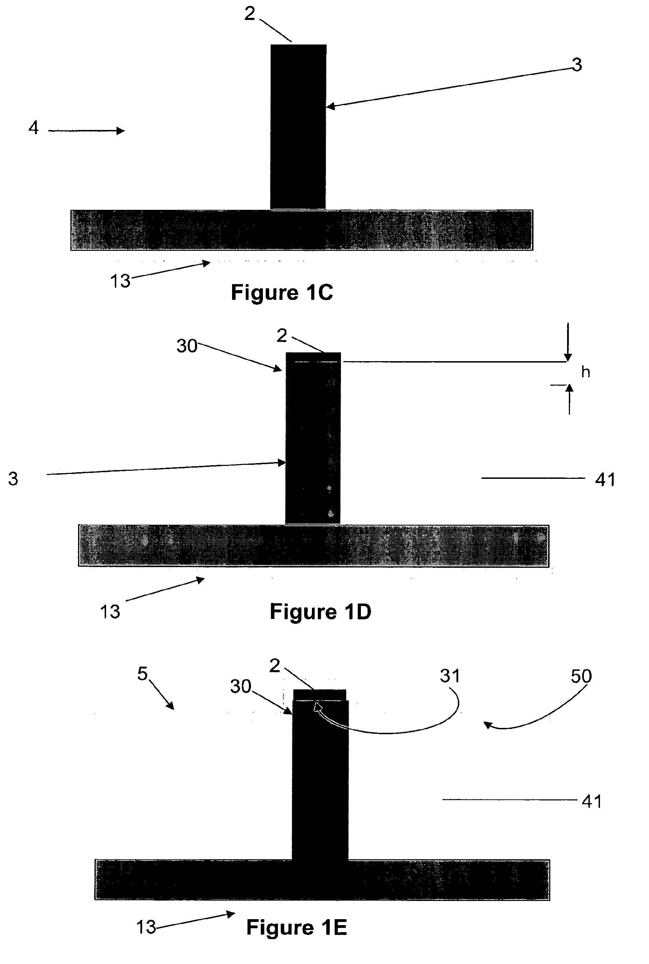

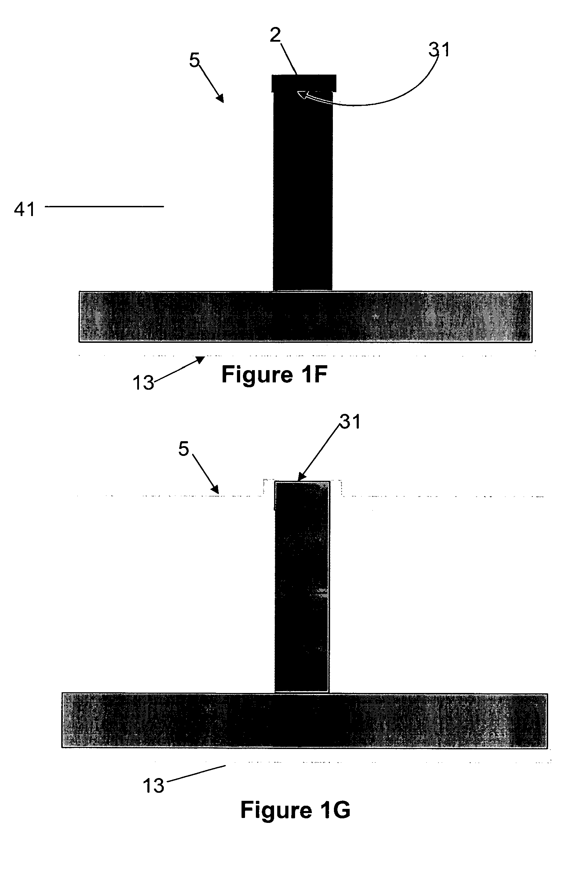

Referring to figure 1, figure 1A illustrates an epitaxial structure 1 obtained by any suitable process. Reference is made to WO 2004/088755. The epitaxial structure can be grown by Chemical Beam Epitaxy method (CBE), but it can also be grown by MBE, MOCVD or MOVPE (Metal-Organic Chemical Vapour Deposition).

The epitaxial structure includes four regions: the epitaxy (regions 10, 11 and 12) and the substrate (region 15).

Regions 10 and 11 are of opposite conductive type. In the illustrated example, region 10 is doped with n-type dopant ions while region 11 is doped with p-type dopant ions. Between these two regions 10 and 11, is defined an intrinsic region 12.

In this example, a GaAs based substrate is used.

Therefore, in the illustrated example, the epitaxial structure consists of the substrate 15 (n doped GaAs), the n doped region 10 (generally consisting of AlAs/GaAs pairs which are called Bragg mirrors), the undoped GaAs layer 12 (cavity) with the active material (InAs quantum dots, InGaAs quantum wells, etc), and the p doped region 11 (generally consisting of AlAs/GaAs pairs).

Figure 1A shows that a first electrical contact area 13 is provided on one face of the substrate 15.

According to figure 1, the method according to the invention is carried out to obtain a device including one micropillar-type semi-conductor as shown on figure 1B. Figure 1A thus shows only one hard mask 2 on the surface 14 of region 11, preferably a nitrited hard mask. This surface 14 is opposite the contact area 13. It is understood that more masks will be provided on the surface 14 to obtain corresponding micropillars.

On planar epitaxial structure 1, lithography and etching of the hard mask (for instance with an SF₆ plasma) is carried out in order to define spatially hard mask 2. The regions 10, 12 and 11 are removed but under the hard mask 2 with etching (for instance with an SiCl₄/Ar plasma), in order to define the micropillar 3 illustrated in figure 1B. A reference can be found in Journal of Vaccum Science and Technology A, vol 7 (3), pages 686-690, May/June 1989.

Figure 1C illustrates a step of planarization of the micropillar 3 by means of a suitable material 4. This material may be a planarizing polymer widely used in the microelectronics field, such as the polymer Accuflo^{®} T27 manufactured by Honeywell.

The following step is an etching of the planariser. The etching is carried out until the micropillar 3 emerges from the remaining planarizing layer 41. As illustrated on figure 1D, the free or top periphery 30 of the micropillar 3 is then exposed on a predetermined height h.

The etching can be for instance carried out with an O₂ plasma.

During the following step illustrated by figure 1E, a layer 5 of an electrical conductive material is provided on the planarizing layer 41. This layer also covers the top periphery 30 of the micropillar 3 and the mask 2.

The conformal deposition of the electrical conductive material is obtained with a sputtering technique. Such a technique is well known in the field of micro-opto electronics. It can be carried out with Ti/Pt/Au metals. Thus, in the case of a p contact on GaAs, three layers are obtained.

As illustrated by figure 1F, the next step is an etching of the layer 5 in order to remove the conductive material located on the mask 2, at the end of the micropillar 3.

Etching is carried out after having protected the layer 5 where it does not contact the mask 2. The protection is obtained by deposition (by spin off) of a photoresist layer. The thickness of the layer will be of around 1 µm except on top of mask 2, where it will be much smaller and easily removed with a short O₂ plasma. Etching is usually carried out with ion beam etching (IBE). The top surface 31 of the micropillar is protected by the mask 2 during etching.

The last step of the process is illustrated by figure 1G and consists in the removal of the hard mask 2 by etching, for instance with an SF6 plasma. A reference can be found in Journal of Vaccum Science and Technology A, vol. 7 (3), pages 686-690, May/June 1989. The top surface 31 of the micropillar is then free of any material.

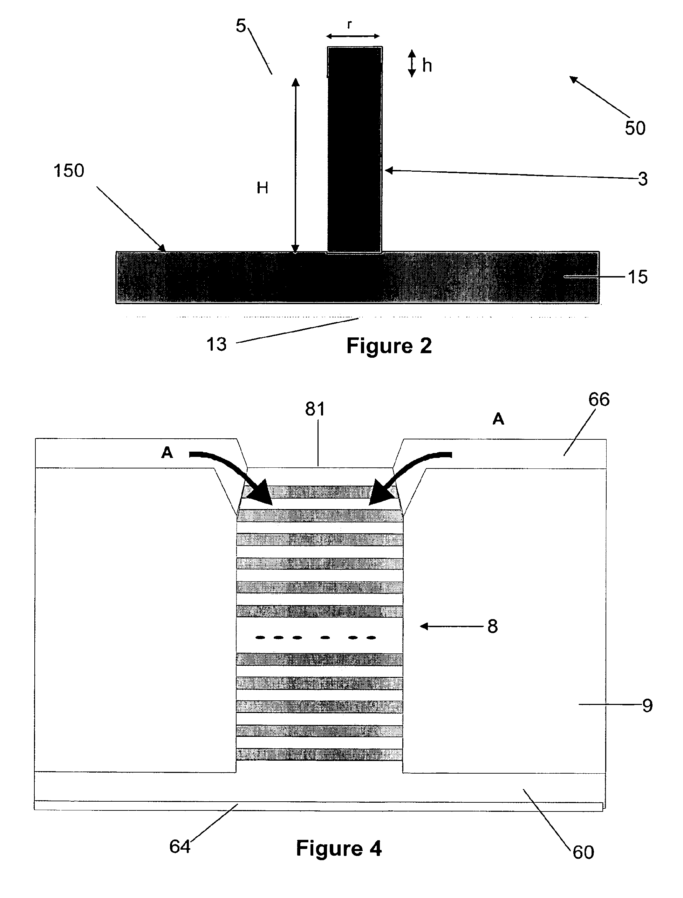

Reference is now made to figure 2 which illustrates a structure obtained by the previous process according to the invention and intended to be used in an optoelectronical device.

In this structure, lateral current injection occurs through the top periphery 30 of the micropillar.

The micropillars height H depends on the number of mirror pairs in the DBRs and is typically between 5 µm and 10 µm. A typical height H of the micropillar is 8µm. The height H is taken between the upper surface 150 of the region 15 and the lower surface 50 of the conductive layer 5.

The height h corresponds to the top periphery 30 of the micropillar 3 which is covered by the conductive material and where injection current can occur.

The micropillar radius r is typically less than 5µm.

In the optoelectronical device illustrated in figure 2, the surface of the contact can be larger than the contact surface of a device obtained through a conventional technique.

As described previously, such a conventional device includes a semi-transparent layer which covers the top surface on the micropillar and provides an electrical contact. This electrical contact is said "p contact", since this layer is in contact with the upper region of the micropillar which is doped with p-type dopant ions.

If r still represents the micropillar radius, the surface of the contact is equal to πr². Therefore, the contact surface is entirely determined by the size of the micropillar.

In the case of an optoelectronical device illustrated on figure 2, the surface of the contact is equal to 2πrh. Therefore, the contact surface depends not only on the size of the micropillar 3, but also on the height of the top periphery of the micropillar which is covered by the conductive material. The parameter h is an adjustable parameter which is independent from the size of the micropillar.

Consequently, if the height h of the lateral injection layer is larger than half the micropillar radius, the contact surface of the optoelectronical device according to the invention is larger than the contact surface of the conventional optoelectronical device, the radius of the micropillar being the same in both devices.

Moreover, the device according to the invention, illustrated in figure 2, includes no absorbing top layer and thus, light efficiency is increased.

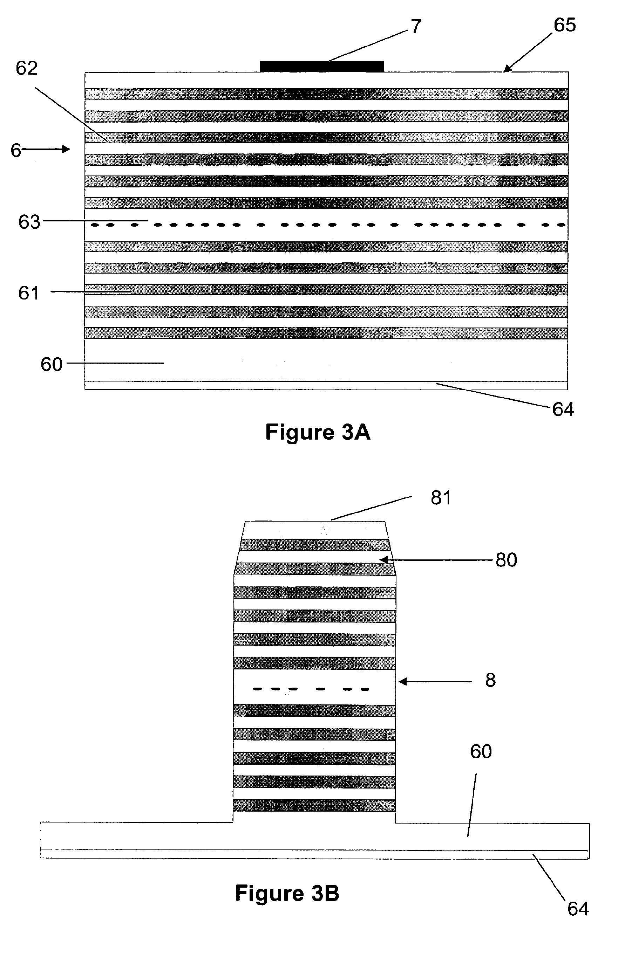

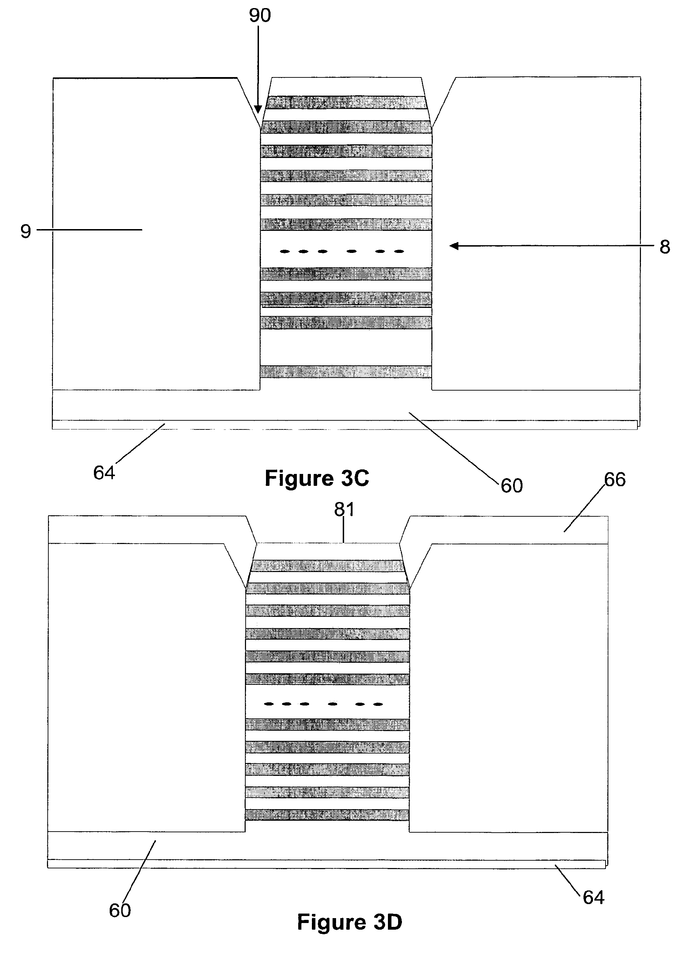

Referring now to figure 3, figure 3A illustrates an epitaxial structure 6 obtained by any suitable process, as previously described.

This epitaxial structure 6 includes four regions: the epitaxy (regions 61, 62 and 63) and the substrate (region 60). Region 61 is doped by n-type dopant ions, while region 62 is doped with p-type dopant ions. Between these two regions 61 and 62, is defined an intrinsic region 63. In this intrinsic region 63, occurs photon generation through radiative recombination.

Figure 3A shows that a first electrical contact area 64 is provided on the epitaxial structure 6. This area 64 is in contact with the substrate 60.

The epitaxial structure 6 can be defined as a planar microcavity structure consisting of a n-doped GaAs substrate (region 60) followed by a n-doped bottom distributed Bragg reflector (DBR) (region 61), a one-λ GaAs cavity containing the active layer (region 63) and the p-doped upper DBR (region 62).

Figure 3A also shows a hard mark 7 on the top surface 65 of region 62. The circular shaped hard mask defines the cross section of the micropillar and is realized by means of high resolution lithography (e.g. electron beam lithography) in conjunction with a lift-off process. This process is for instance described in S. Wolf and R.N. Tauber, Silicon Processing for the VLSI Era Vol. 1, Lattice Press.

The hard mask is used as an etching mask when regions 61, 62 and 63 are removed in a subsequent etching process as described below. Hard mask 7 consists either of a Nickel (Ni) or a Barium Fluoride (BaF₂/Cr) layer formed by metal deposition.

High resolution lithography (electron beam lithography) is used to define the micropillar 8. This process is for instance described in P. Rai-Choudhury, Editor, SPIE Handbook of Microlithography, Micromachining and Microfabrication, Volume 1: Microlithography.

As explained in reference to figure 1, several hard masks are provided on the top surface 65 in case several micropillars are to be obtained.

At this stage, the mask 7 is still on the top surface 80 of the micropillar.

Figure 3B illustrates the following step which forms the micropillar and results in a complete removal of the hard mask. In case of a BaF₂/Cr hard mask, the BaF₂ layer remains on the surface after etching. BaF₂ layer is then removed after planarization by H₂O.

This etching is carried out by Ar/Cl₂ assisted RIE - ECR etching (Reactive Ion Etching - Electron Cyclotron Resonance). Reference is made to US-5 401 351 or Randy J. Shul, Stephen J. Pearton, Handbook of Advanced Plasma Processing Techniques, Springer, ISBN 3540667725.

This hard mask is then transferred into the semi-conductor material, the doped GaAs/AlGaAs DBR layers (regions 61 and 62) as well as the one-λ. GaAs cavity containing the active layer (region 63). Reference is made to the process described above in reference with figure 1B.

As shown in figure 3B, RIE-ECR etching results in a tapered shape at the upper part of the micropillar 8. The tapered shape is not unique for RIE-ECR etching but is also seen for micropillars etched by the RIE-ICP (Inductively Coupled Plasma) technique, cf. A. Löffler, et al, Appl. Phys. Lett. 86,111105 (2005). Information about RIE-ICP is included in Handbook of Plasma Processing Techniques, Randy J. Shul, Stephen J. Pearton, Springer, ISBN 3540667725.

Therefore, the top periphery 80 of the micropillar 8 has a cross-section which increases from the top surface 81 of the micropillar to the rest of the micropillar, towards region 60.

Figure 3C illustrates a step of planarization of the micropillar 8 by means of a suitable material such as benzocyclobutene BCB. The process should also work with other planarizers provided that the planizer-semiconductor (γₚₛ) and planarizer-air (γₚₐ) surface tensions, respectively, lead to an contact angle smaller the 90°, i.e., γₚₐ > γₚₛ

Figure 3C shows that, after planarization, a generally annular air gap 90 is obtained between the micropillar 8 and the layer 9 of planariser.

Figure 3D illustrates the last step of the method according to the invention. This step consists in forming a layer of conductive material 66. This layer 66 is formed in order to leave exposed the top surface 81 of the micropillar 8.

Lithography and metallization can be used to provide this "p-contact". More precisely, the ring-shaped p-contact is defined by means of electron-beam lithography into PMMA (Polymethylmethacrylat, electron-beam sensitive resist) after planarization. Afterwards, the lift-off technique is applied to form the ring contact and to remove the PMMA at the unexposed regions. During this process, the top surface of the pillar is never covered by the conductive material.

This layer 66 can be an Pt/Au layer with a thickness of about 100nm.

Reference is now made to figure 4 which illustrates a structure obtained by the process described with regard to figure 3 and intended to be used in an optoelectronical device.

As mentioned with regard to figure 2, the radius r of the micropillar is usually less than 5µm, for instance a diameter of 3µm.

The arrows A show how the lateral current injection occurs in the micropillar 8.

This structure allows efficient lateral current injection through the upper layers of the p-doped region 82, while keeping the top surface 81 free of any semi-transparent material which absorbs part of the light emitted by the structure.

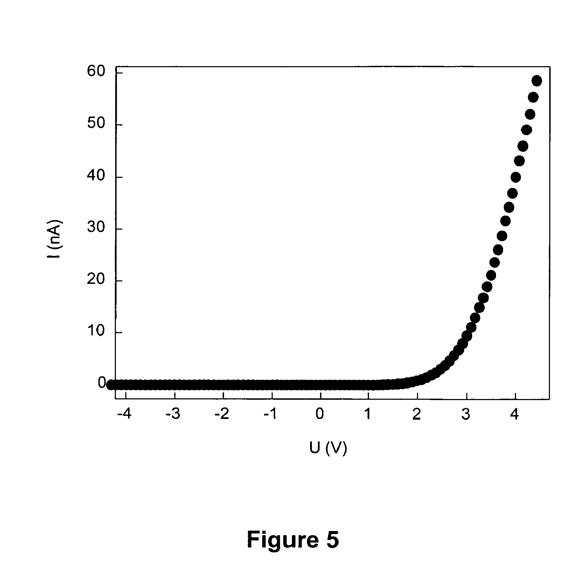

The efficiency of the lateral current injection is illustrated by figure 5. Figure 5 is a curve which is a representation of the function I (U), where I is the current flowing in the structure of figure 4, and U the voltage applied to the structure.

The current flow is observed only in forward direction, i.e. for positive voltage applied to the structure.

This curve corresponds to a micropillar with a diameter of about 3 µm, at room temperature.

It can be noted that the curve I(U) should be the same for the device illustrated in figure 2. In the case of the device illustrated in figure 2, only one lithography step (definition of the hard mask 2) is required, and it should be easier to control the contact surface (imposed by r and h).

The previous description shows that the method according to the invention provides an optoelectronical device with micropillar-like semi-conductors, which avoids any semi-transparent conductive layer covering the top surface of the micropillars.

The electrical contact area on a micropillar is obtained by means of a conductive material provided on the top periphery of the micropillar. This top periphery is located at the end of the micropillar which is opposite the substrate. Moreover, the top surface of the micropillar is totally exposed. Therefore, this electrical contact area does not impede the emission or the reception of light.

An optoelectronical device according to the invention has a larger electrical contact than conventional devices, when the height of the lateral injection layer is larger than half the micropillar radius.

Finally, the current injection in a device according to the invention is improved. The lateral injection geometry will allow improving the efficiency of micropillar based electrically-driven single photon sources.

The method according to the invention can be carried out to realise a new type of VCSELs, without ionic implantation nor lateral oxidation with a much smaller lateral extension.

An example of such a VCSEL comprises one micropillar obtained by means of the method according to the invention.

The diameter of a conventional VCSEL is in the range 35-50µm, whereas current injection in the active layer occurs in a diameter of about 5µm.

By contrast, a new VCSEL consisting of one micropillar would have a diameter of about 5µm only. In other words, the current could flow through the whole surface of the new device.

Consequently, a VCSEL according to the invention presents a much higher integration density. This can induce a reduction of the cost per device. It also enables the realisation of matrices of VCSELs, thus increasing the power emitted by unit surface.

Finally, the method according to the invention can be used to realise electrically-driven single photon sources with a high efficiency, micropillar based photon detectors with a high efficiency, low cost VCSELs and arrays of VCSELs.

## Claims

1. Method of producing an optoelectronical device including at least one micropillar-like semi-conductor, comprising:
- forming at least one micropillar (3, 8) from a planar microcavity structure (1, 6),
- providing a first electrical contact area on the said structure,
- providing a second electrical contact area on the said at least one micropillar,
wherein the second electrical contact area is provided on the top periphery (30, 80) of the said at least one micropillar (3, 8), opposite the said structure (1, 6), its top surface (31, 81) being free of any material, to enable lateral electrical injection.

2. Method as claimed in claim 1, wherein the second electrical contact area is produced by deposition of a layer of an electrical conductor material.

3. Method as claimed in claims 1 or 2, wherein the second electrical contact area is created after the said at least one micropillar is formed.

4. Method as claimed in anyone of claims 1 to 3, wherein forming the said at least one micropillar comprises the steps of:
- providing at least one hard mask (2, 7) on the said planar microcavity structure,
- etching the said structure in order to define the said at least one micropillar (3, 8).

5. Method as claimed in claim 4, wherein the said at least one hard mask (2) is left on the top surface (30) of the said at least one micropillar (3), during the realization of the second electrical contact area.

6. Method as claimed in claim 5, wherein providing the second electrical contact area comprises the steps of:
- planarizing the said at least one micropillar (3),
- etching the planariser in order to expose the said at least one micropillar (3) on its top periphery (30),
- forming a layer of conductive material (5) which covers the top periphery of the micropillar and the hard mask,
- etching the said at least one micropillar (3) in order to remove the conductive material (5) from the hard mask (2) while it remains on its top periphery (30),
- removing the hard mask (2).

7. Method as claimed in claim 6, wherein the said layer of conductive material (5) is obtained by conformal disposition.

8. Method as claimed in claims 6 or 7, wherein etching is carried out after having protected the top periphery (30) of the said at least one micropillar (3).

9. Method as claimed in claim 4, wherein the said at least one hard mask (7) is completely removed from the top surface (81) of the said at least one micropillar (8), before the realization of the second electrical contact area, whereby the top periphery (80) of the said at least one mircopillar is generally tapered.

10. Method as claimed in claim 9, wherein providing the second electrical contact area comprises the steps of:
- planarizing the said at least one micropillar (8),
- forming a layer of conductive material (66) which leaves exposed the top surface (81) of the said at least one micropillar.

11. Method as claimed in claim 10, wherein the said layer of conductive material (66) is obtained by lithography and metallization.

12. Structure for an optoelectronical device including at least one micropillar-like semi-conductor (3, 8) and having an electrical contact area on the periphery of the said at least one micropillar, located close to a free end of the said at least one micropillar, the said free end (31, 81) being not involved in the electrical contact.

13. Structure as claimed in claim 12, wherein the said electrical contact area comprises a layer of a conductive material (5, 66) which leaves exposed the free end (31, 81) of the said at least one micropillar (3,8).

14. Structure as claimed in claim 13, wherein the said periphery (80) of the said at least one micropillar (8) has a tapered shape.
